# EUROPEAN PATENT SPECIFICATION

(11) **EP 0 289 157 B1**
(45) Date of publication and mention of the grant of the patent: **14.12.1994**
(21) Application number: 88303219.5
(22) Date of filing: 11.04.1988
(51) Int. Cl.: H01R 13/70, H05K 7/14, G06F 13/40

(54) **Electrical keying for replaceable modules**
Elektrische Kodierung für ersetzbare Module
Codage électrique pour modules interchangeables

(30) Priority: 17.04.1987 US 40454
(43) Date of publication of application: 02.11.1988
(73) Proprietor: TANDEM COMPUTERS INCORPORATED, Cupertino California 95014-2599 (US)
(72) Inventor: Zacher, Richard A., Los Gatos California 95030 (US); Zwagerman, Jay A., Saratoga California 95070 (US); Dwan, Francis J., Gilroy California 95020 (US)
(74) Representative: Ayers, Martyn Lewis Stanley

(56) References cited:
- DE-C- 3 603 524
- GB-A- 2 153 567
- US-A- 3 957 333
- US-A- 4 490 775

## Description

### BACKGROUND OF THE INVENTION

A typical computer system includes a cabinet which houses a number of replaceable modules. These modules may include power supplies, fans, mass storage devices, central processing units, and controllers for input-output devices. Repair of the system is usually effected by removing a defective module and replacing it with a correctly functioning module of the same type. In some kinds of systems which incorporate redundant modules, one part of the system can be repaired while the rest of the system is functioning; then the repaired part can be reintegrated without ever shutting down the system.

When modules are replaced, it is essential that the replacement module be of the correct type. If a module of one type is inserted into a site designed for a module of a different type, damage may occur to the module or to the rest of the system.

In many cases, difference in shape between modules preclude insertion of one type of module into a site not designed for it. For example, a disc unit and a power supply typically are of very different shapes and have electrical connectors which are physically incompatible, so it may be impossible to insert one into a slot designed for the other in such a way as to cause damage. On the other hand, other types of modules may be designed to be physically similar for reasons of economy. In particular, electronic modules realized as assemblies of components mounted on printed wiring boards may be designed in a standard form to plug into physically identical slots in a common housing, or card cage. Because the connections to modules of different types may differ, a potential for damage exists if a module can be plugged into a slot not designed for it.

One way of avoiding such damage is to provide mechanical keying on the slots of the card cage. The plug-in modules have complementary keying, designed so that a module can plug only into a slot designed for it. This scheme works well in certain portions of a computer system where a given slot is intended to accept only one type of module. It can also work for portions of the system where slots are designed to accommodate any of several different types of modules. For example, a section of a card cage may contain several slots set aside for modules which control input/output (I/O) devices. The types and numbers of I/O devices may vary from system to system, so the slots in this section may be designed to accommodate any of the controller modules. All I/O controller modules would be keyed alike to prevent their insertion into slots not designed for I/O controllers, and to allow their insertion into any I/O controller slot. Other modules would be keyed to prevent their insertion into the I/O controller slots.

A problem arises if modules in this I/O controller section are paired. In one scheme, for example, each I/O controller comprises two modules: one which contains most of the logic circuitry of the controller, and another which holds specialized interface circuitry and connectors for connection to a device or communication line of a specific type. For clarity, the first type of module is designated the LB (for Logic Board) and the second type of module the AB (for Adaptor Board). There may be several types of LB, each electrically compatible with several types of AB; however an AB electrically compatible with a particular LB type is electrically incompatible with all other LB types. The problem is that if an LB and an electrically incompatible AB are plugged into paired slots, damage may result when power is applied to the circuitry on either board.

Further, when connection is made between the boards and power and signal contacts, arcing or power supply voltage drop may cause damage to the boards or loss of data.

Accordingly, a system for preventing power-up when an incompatible board pair is interconnected would be of great utility. Further, it would be useful for the system to prevent arcing and loss of data during interconnection.

GB-2153567 discloses a printed circuit expansion back plane bearing a plurality of sockets. Four address contacts are provided in each socket, selectively connected in different combinations to 5 and 0 volt power supplies so to create a unique binary address for each socket. Devices plugged into each socket contain combinational logic designed to respond to address data received from an outside source (i.e., a computer) and the address contacts of a particular socket, thereby enabling selective accessing of each device/socket combination. Such combinational logic may be constructed from exclusive-OR and NOR logic gates.

The present invention seeks to provide an electromechanical interconnect system which does not depend on the use of circuitry performing combinational logic or similar switching functions. DE-C-3603524 discloses an electromechanical interconnect system in which a plug which conveys output signals from a microprocessor is provided with extra pins which may or may not be bridged in order for an output signal protocol appropriate for the device attached to the plug to be identified.

According to the present invention, there is provided an electromechanical interconnect system comprising a panel having at least two connector arrays of electrical contacts, and modules each having a respective connector array of contacts mechanically compatible for connection to one of said panel connector arrays wherein the panel is capable of mechanically and electrically interconnecting two modules from a first and a second set of modules respectively when the module connector arrays of said two modules are connected to different panel connector arrays, particular modules from said first set of modules being electrically incompatible when electrically interconnected with particular modules from said second set of modules, said system having
a subsystem for assuring that power cannot be applied to a given pair of first and second interconnected modules unless they are electrically compatible modules, said subsystem comprising:
a first set of keying contacts included in the module connector array of said first module;
a second set of keying contacts included in the module connector array of said second module;
a power supply control regulator circuit coupled to a pair of control regulator terminals;
means included in said panel for electrically connecting respective pairs of keying contacts of said first and second modules when said first and second modules are interconnected, thereby electrically interconnecting the keying contacts of said first and second modules;
means for electrically connecting said first control regulator terminal to a first keying contact in said first set and a second control regulator terminal to a second keying contact in said first set;
means for electrically connecting at least one selected other pair of keying contacts in said first set to form a first wiring pattern; and
means for electrically connecting at least two selected pairs of keying contacts in said second set to form a second wiring pattern;
switching means for applying power to said modules when they are interconnected only if said four means for electrically connecting respective contacts and/or terminals form a closed circuit which extends back and forth between the modules via the panel between said pair of control regulator terminals;
and having said first and second wiring patterns chosen in such a way that there is a closed circuit between the pair of control regulator terminals when said first and second modules are interconnected only if said first and second modules are electrically compatible.

Thus, the present invention provides an electromechanical interconnect system for interconnecting a module pair, or a set of pin-compatible module pairs, that prevents power-up of an interconnected pair if the module connectors of the pair are electrically incompatible.

The keying contacts on the various modules are coupled so that the control terminals are conductively connected when electrically compatible modules are interconnected, to supply power to the modules, and so that the control terminals are not conductively connected if the interconnected modules are electrically incompatible, to prevent the supply of power to the modules.

In one embodiment, at least one keying contact is included in an upper, centre, and lower row of keying contacts to prevent arcing between power or signal contacts due to geometrical misalignment or backpanel bowing.

In another embodiment, the controllable switch is not on either module.

Other advantages and features of the invention will be apparent in view of the drawings and following detailed description.
Figure 1 is a schematic diagram illustrating the operation of the electromechanical interconnect system of the invention;
Figure 2 is a schematic diagram of a preferred embodiment of the invention;
Figure 3 is a side view depicting geometrical misalignment;
Figure 4 is a slide view depicting back panel bowing.

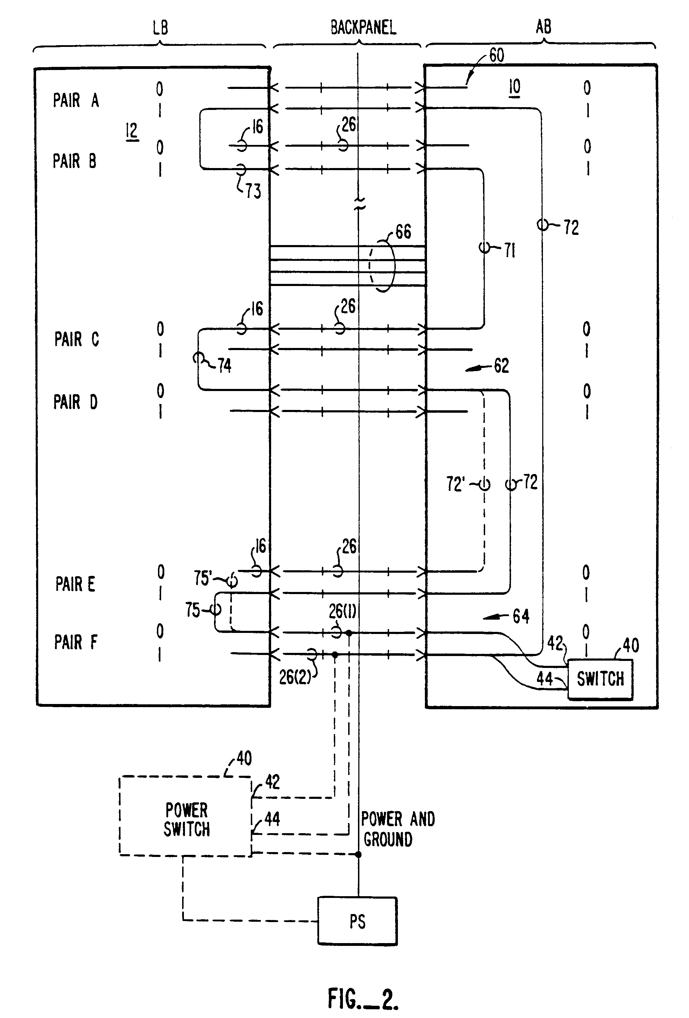

Referring now to the drawings, where like reference numerals indicate identical or corresponding parts throughout the several views, Figure 1 is a schematic diagram illustrating the electromechanical interconnect system of the invention. In Figure 1, a module pair comprises first module 10 and second module 12. The first module includes a first module connector array 14 having six conductive receptacles 16A-F as contacts. Similarly, the second module includes a second module connector array 15 including six conductive receptacles 16G-L as keying contacts. A back panel 20 has a first major face whereupon a first panel connector array 22 is mounted and a second major face whereupon a second panel connector array 24 is mounted. Each panel connector array 22 and 24 includes six conductive pins as keying contacts (26A-F for the first array and 26G-L for the second array). The conductive pins 26 and conductive receptacles 16 are equally spaced so they may be mechanically and conductively mated when the first and second module connector arrays 14 and 15 are mechanically connected to the panel connector arrays.

Further, the backpanel 20 includes mechanical positioning pins 30 and 32 and the first and second module connector arrays 14 and 15 include mechanical receptacles 34 and 36.

The first module 10 includes a control regulator 40 that distributes power to the first and second modules, when they are interconnected via the backpanel 20, only if first and second control terminal 42 and 44 are electrically connected. The control regulator 40 is connected to an external power source via power and signal pins in the panel arrays 22 and 24 and distributes power to the modules via other power and signal pins. The external power supply, signal and power pins and interconnections are not explicitly depicted in Figure 1 but are realised in a standard manner.

The first module 10 includes a wiring path 50 which connects conductive receptacles 16C with the first terminal of the regulator 42 and a wiring path 51 which connects receptacle 16D to the second terminal of the regulator 44. Additionally, the first module includes a wiring path 52 coupling the first conductive receptacle 16A with the sixth conductive receptacle 16F. The second module 12 includes a wiring path 53 coupling the seventh conductive receptacle 16G with the ninth conductive receptacle 16I and a wiring path 54 connecting the tenth conductive receptacle 16J to the twelfth conductive receptacle 16L. Typically, these wiring paths 50-54 are circuit lines etched on a printed circuit board.

The conductive pins 26, in the first and second panel connector arrays 22 and 24 disposed opposite to each other, e.g. pins 26A and 26G, are electrically connected through the back panel 20.

The operation of the electromechanical interconnect system will now be described. For the wiring system described above, when the receptacles in the first and second module connector arrays 14 and 15 are mated to corresponding pins 26 in the backpanel connector arrays 22 and 24, a complete circuit from first terminal 42 through receptacles 16C, 16I, 16G, 16A, 16F, 16L, 16J 16D back to second terminal 44 is completed. Accordingly, a circuit is formed between first and second terminals 42 and 44 and the regulator 40 provides power to the interconnected module pair.

The above-described wiring system is thus appropriate in the case where the first and second modules 10 and 12 are electrically compatible. The pattern of wiring provides for application of power when the conductive receptacles 16 are mated to the conductive pins 26. On the other hand, if wiring path 54 were removed and replaced by the wiring path indicated by the dotted line 60 then a complete circuit would not be formed between first and second terminals 42 and 44 when the receptacles 16 and pins 26 were mated. This scheme of wiring would be appropriate for a first and second module that were not compatible because power would not be applied to the module pair when the receptacle 16 and pins 26 were mated. However, if additionally the wiring path 52 on the first module was replaced by the wiring path indicted by the dotted line 62 then a completed circuit would be formed between first and second terminals 42 and 44 and power would be applied to the module pair.

Thus, a system for keying different module pairs has been described. Note that the connector arrays of all modules are mechanically compatible with the panel connector arrays. However, by varying the wiring patterns of the first and second modules 10 and 12, the modules are keyed so that power may only be applied to compatible modules.

Figure 2 is a schematic diagram of a preferred embodiment of the invention. The conductive pins 26 are disposed in three rows, an upper row 60 positioned near the top of the back panel 20, a centre row 62 positioned near the centre of the back panel 20, and a bottom row 64 positioned near the bottom of the backpanel 20. Similarly, the conductive receptacles 16 are disposed in corresponding upper, middle and lower rows in the first and second module connector arrays 14 and 15. Also disposed along the backpanel 20 are multiple rows of signal and power pins 66. The power and signal pins 66 are longer than the conductive pins 26. The conductive pins 26 and receptacles 16 are grouped into adjacent pairs.

In Figure 2, the receptacles in each adjacent pair are labelled by the binary digits 0 and 1. In each module, one of the receptacles in each adjacent pair is connected to another receptacle in another adjacent pair by wiring paths 70-75.

For a compatible module pair, as shown in Figure 2, these wiring paths form a short circuit between first and second switch terminals 42 and 44 when the receptacles 16 are mated to the pins 26.

For an incompatible module pair, these wire paths would not form a short circuit between the switch terminals 42 and 44. For example, if in Figure 2, assume wiring path 72 were in the first module 10 were replaced by wiring path 72' (dotted line), a short circuit would not be formed when the modules 10 and 12 were interconnected via the backpanel 20.

However, if, in the second module 12, wire path 75 were replaced by wire path 75', a second compatible pair would be formed.

Alternatively, as shown in phantom in Figure 2, the regulator 40 may be external to the interconnect system. In that case, the control terminals 42 and 44 are coupled to given pair of conductive pins 26(1) and 26(2). The wiring paths on the first and second modules 10 and 12 form a wiring path between the given pair of conductive pins 26(1) and 26(2) only if the module pair 10 and 12 is electrically compatible.

The receptacles in the first and second module connector arrays are all of the same length and are geometrically arranged so that each pin mates with a corresponding receptacle when the first and second modules 10 and 12 are connected to the panel connector arrays 22 and 24 thereby interconnecting the modules 10 and 12. Because the signal and power pins 66 are longer than the conductive pins 26 the electrical connections between the receptacles in the module connectors and the signal and power pins 66 are made before the electrical connections between the receptacles and the conductive pins 26. Thus, no power is applied before the mechanical connection between the signal and power pin 66 and the associated receptacles and, therefore, the problem of arcing between the power pins 66 and receptacles is obviated.

Further, the regulator 40 provides for linear ramping of the initial voltage applied to the boards so that there is no current surge that could cause the power supply out put voltage to drop when the boards are first interconnected. Thus, there is no danger that data stored on other boards supplied by the power supply will be lost.

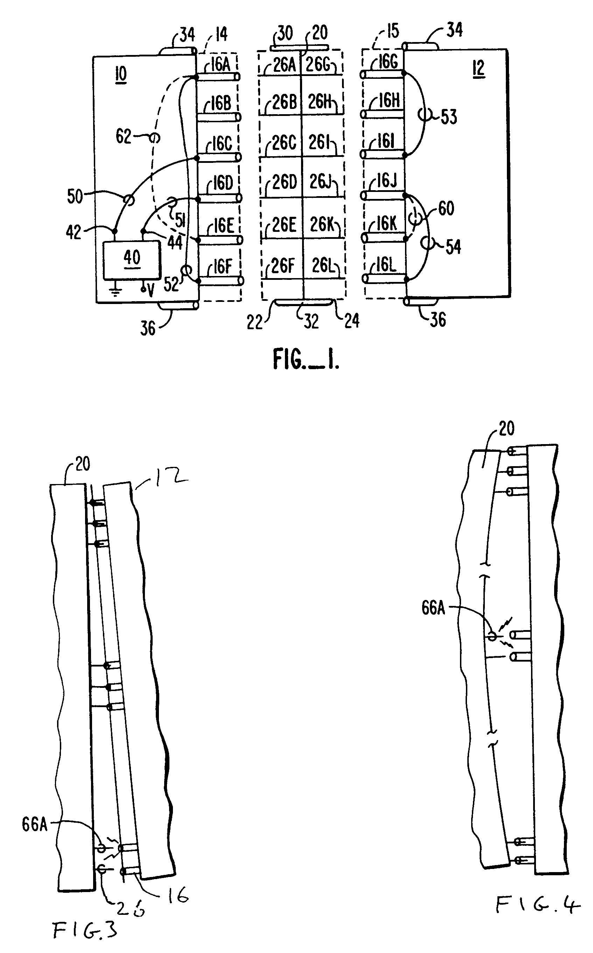

The wiring paths described above in Figure 1 are depicted in analogous form for Figure 2. Note that for each module, three conductive pin pairs are connected. At least one of these connecting conductive pin pairs must be in each of the conductive pin rows 60, 62 and 64. This prevents accidental powerup if the modules are geometrically misaligned during the mechanical mating of the pins and receptacles or if the backpanel has become warped or bowed. These effects are illustrated in Figures 3 and 4.

In Figure 3, assume that all of the conductive pins 26 necessary to complete the short circuit were in the upper keying pin row 60. The second module 12 is misaligned during the mechanical mating step so that the short circuit is completed prior to the interconnection of power pin 66A with its corresponding receptacle 16 in the second connector array 15. Since power has been applied due to the completion of the short circuit, there may be an arc between the power pin and the receptacle. In Figure 3, the misalignment angle has been greatly exaggerated to illustrate the effect. However, typically the difference between the short and long pins is only 40 mils so that a minor misalignment could lead to the effect described.

However, if one of the conductive pins is in the lower row 64 then power will not be supplied until this pin is mated, where this mating occurs after the signal and power pin 66A has been mated.

In Figure 4, assume that all of the conductive pins required to complete the powerup circuit are in the upper and lower keying rows 60 and 64. The backpanel is bowed so that the upper and lower rows of conductive pins are connected to complete the power circuit before a power pin 66A near the centre of the connector is connected to its corresponding receptacle 16 in the first module connector array 14. Thus, an arc may develop between the power pin 66A and its associated receptacle. Again, as in Figure 3, the drawing has been exaggerated to show the effect.

However, if one of the conductive pins is in the middle row 62, then power will not be supplied until this pin is mated, where this mating occurs after power and signal pin 66A is mated.

The invention has now been described with reference to a preferred embodiment. Substitutions and modifications will now be apparent to those skilled in the art. In particular, the distribution of pins and receptacles between the module connectors and back panel connectors is not material to the invention. Any combination of pins and receptacles, or any other type of mechanically mating contacts in either connector array could be utilized to practice the invention. Further, the short/long relationship between the keying interconnect system and the signal and power interconnect system may be implemented by various combinations of short and long pins and receptacles. For the embodiment having upper, middle and lower keying rows, if one keying pin in each row is shorter than the signal and power pins, then the advantages regarding arcing and data preservation will be realized. Accordingly, it is intended that the invention not be limited except as provided by the appended claims.

## Claims

1. An electromechanical interconnect system comprising a panel (20) having at least two connector arrays (22,24) of electrical contacts, and modules (10,12) each having a respective connector array (14,15) of contacts mechanically compatible for connection to one of said panel connector arrays (22,24), wherein the panel is capable of mechanically and electrically interconnecting two modules from a first and a second set of modules respectively when the module connector arrays of said two modules are connected to different panel connector arrays, particular modules from said first set of modules being electrically incompatible when electrically interconnected with particular modules from said second set of modules, said system having
a subsystem for assuring that power cannot be applied to a given pair of first and second interconnected modules (10,12) unless they are electrically compatible modules, said subsystem comprising:
a first set of keying contacts (16A-F) included in the module connector array (14) of said first module (10);
a second set of keying contacts (16G-L) included in the module connector array of said second module (12);
a power supply control regulator circuit (40) coupled to a pair of control regulator terminals (42,44);
means included in said panel (20) for electrically connecting respective pairs of keying contacts of said first and second modules when said first and second modules are interconnected, thereby electrically interconnecting the keying contacts of said first and second modules;
means (50,51) for electrically connecting said first control regulator terminal (42) to a first keying contact (16C) in said first set (16A-F) and a second control regulator terminal (44) to a second keying contact (16D) in said first set (16A-F);
means (52) for electrically connecting at least one selected other pair of keying contacts (16A,16F) in said first set to form a first wiring pattern; and
means (53,54) for electrically connecting at least two selected pairs of keying contacts (16G,I,J,L) in said second set to form a second wiring pattern;
switching means for applying power to said modules when they are interconnected only if said four means for electrically connecting respective contacts and/or terminals form a closed circuit which extends back and forth between the modules via the panel between said pair of control regulator terminals (42,44);
and having said first and second wiring patterns chosen in such a way that there is a closed circuit between the pair of control regulator terminals (42,44) when said first and second modules are interconnected only if said first and second modules are electrically compatible.

2. The system of claim 1 wherein said connector arrays are substantially rectangular and at least one of said module keying contacts of said first set is disposed near the top (60) of the module connector array, at least one of said keying contacts in the first set is disposed near the centre (62) of the module connector array, and at least one of said module keying contacts of said first set is disposed near the bottom (64) of the module connector array.

3. The system of claim 2 wherein said panel connector arrays (22,24) include panel keying pins (26) for contact with said keying contacts (16A-L) of said module connector arrays when said module connector arrays are connected to said panel connector arrays, and power and signal pins (66), said power and signal pins (66) being longer than said panel keying pins (26).

4. The system according to any one of the preceding claims where said switching means does not form part of either module.

## Patentansprüche

1. Elektromechnisches Verbindungssystem, enthaltend ein Panel (20) mit wenigstens zwei Verbindergruppen (22, 24) von elektrischen Kontakten und Module (10, 12), von denen jedes jeweils eine Verbindergruppe (14, 15) von Kontakten hat, die mechanisch zur Verbindung mit einer der Panel-Verbindergruppen (22, 24) kompatibel sind, wobei das Panel geeignet ist, zwei Module aus jeweils einem ersten und einem zweiten Satz von Modulen mechanisch und elektrisch miteinander zu verbinden, wenn die Modul-Verbindergruppen der zwei Module mit verschiedenen Panel-Verbindergruppen verbunden sind, wobei bestimmte Module von dem ersten Satz von Modulen elektrisch inkompatibel sind, wenn sie mit bestimmten Modulen von dem zweiten Satz von Modulen verbunden sind, wobei das System hat
ein Subsystem zum Sicherstellen, daß keine Spannung an ein bestimmtes Paar von ersten und zweiten verbundenen Modulen (10, 12) angelegt werden kann, außer sie sind elektrisch kompatible Module, wobei das Subsystem enthält:
einen ersten, in der Modul-Verbindergruppe (14) des ersten Moduls (10) enthaltenen Satz von Kodierungskontakten (16A - F),
einen zweiten, in der Modul-Verbindergruppe des zweiten Moduls (12) enthaltenen Satz von Kodierungskontakten (16G - L),
eine Energieversorgungssteuerung-Regelschaltung (40), die mit einem Paar von Steuerungs-Regelanschlüssen (42, 44) gekoppelt ist,
in dem Panel (20) enthaltenen Einrichtungen zur elektrischen Verbindung von jeweiligen Paaren von Kodierungskontakten der ersten und zweiten Module, wenn die ersten und zweiten Module verbunden sind, wodurch die Kodierungskontakte der ersten und zweiten Module elektrischen verbunden sind,
Einrichtungen (50, 51) zum elektrischen Verbinden des ersten Steuerungs-Regelanschlusses (42) mit einem ersten Kodierungskontakt (16C) in dem ersten Satz (16A - F) und eines zweiten Steuerungs-Regelanschlusses (44) an einen zweiten Kodierungskontakt (16D) in dem ersten Satz (16A - F),
Einrichtungen (52) zum elektrischen Verbinden wenigstens eines ausgewählten weiteren Paares von Kodierungskontakten (16A, 16F) in dem ersten Satz, um ein erstes Schaltungsmuster zu bilden, und
Einrichtungen (52) zum elektrischen Verbinden wenigstens ausgewählter Paare von Kodierungskontakten (16G, I, J, L) in dem zweiten Satz, um ein zweites Schaltungsmuster zu bilden,
Schalteinrichtungen zum Anlegen von Spannung an die Module, wenn sie verbunden sind, nur dann, wenn die vier Einrichtungen zum elektrischen Verbinden jeweiliger Kontakte und/oder Anschlüsse einen geschlossenen Stromkreis bilden, der sich sich durch das Panel zwischen dem Paar von Steuerungs-Regelanschlüssen (42, 44) zwischen den Modulen hin und her verläuft,
und wobei die ersten und zweiten Schaltungsmuster in einer deratigen Weise gewählt sind, daß es, wenn die ersten und zweiten Module verbunden sind, zwischen dem Paar von Steuerungs-Regelanschlüssen (42, 44) nur dann einen geschlossenen Stromkreis gibt, wenn die ersten und zweiten Module elektrisch kompatibel sind.

2. System nach Anspruch 1,
dadurch gekennzeichnet,
daß die Verbindergruppen im wesentlichen rechteckig sind, und daß wenigstens einer der Modul-Kodierungskontakte des ersten Satzes in der Nähe des oberen Endes (60) der Modul-Verbindergruppe angeordnet ist, wenigstens einer der Modul-Kodierungskontakte des ersten Satzes in der Nähe der Mitte (62) der Modul-Verbindergruppe angeordnet ist und wenigstens einer der Modul-Kodierungskontakte des ersten Satzes in der Nähe des unteren Endes (64) der Modul-Verbindergruppe angeordnet ist.

3. System nach Anspruch 2,
dadurch gekennzeichnet,
daß die Panel-Verbindergruppen (22, 24) Panel-Kodierungsstifte (26) zum Verbinden mit den Kodierungskontakten (16A - L) der Modul-Verbindergruppen, wenn die Modul-Verbindergruppen mit den Panel-Verbindergruppen verbunden sind, und Energie- und Signalstifte (66) enthalten, wobei die Energie- und Signalstifte (66) länger als die Panel-Kodierungsstifte (26) sind.

4. System nach einem der vorhergehenden Ansprüche,
dadurch gekennzeichnet,
daß die Schalteinrichtungen keinen Teil irgend eines Moduls bilden.

## Revendications

1. Système d'interconnexion électromécanique comprenant un panneau (20) ayant au moins deux rangées de connecteurs (22, 24) à contacts électriques, et des modules (10, 12) ayant chacun une rangée de connecteurs respectifs (14, 15) à contacts mécaniquement compatibles pour connexion à l'une desdites rangées de connecteurs de panneau (22, 24), dans lequel le panneau est capable d'interconnecter mécaniquement et électriquement deux modules respectivement à partir d'un premier et d'un second jeu de modules lorsque les rangées de connecteurs de module desdits deux modules sont connectées à des rangées de connecteurs de panneau différentes, des modules particuliers à partir dudit premier jeu de modules étant électriquement incompatibles lorsque électriquement interconnectés avec des modules particuliers dudit second jeu de modules, ledit système possédant
un système secondaire pour assurer que le courant ne peut pas être appliqué à une paire donnée de premier et second modules interconnectés (10, 12) à moins que ce ne soit des modules électriquement compatibles, ledit système secondaire comprenant :
un premier jeu de contacts de codage (16A à F) inclus dans la rangée de connecteurs de module (14) dudit premier module (10) ;
un second jeu de contacts de codage (16G à L) inclus dans la rangée de connecteurs de module dudit second module (12) ;
un circuit de régulation de commande d'alimentation en courant (40) relié à une paire de bornes de régulation de commande (42, 44) ;
un moyen inclus dans ledit panneau (20) pour connecter électriquement les paires respectives des contacts de codage desdits premier et second modules lorsque lesdits premier et second modules sont interconnectés, interconnectant électriquement, par ce moyen, les contacts de codage desdits premier et second modules ;
des moyens (50, 51) pour connecter électriquement ladite première borne de régulation de commande (42) à un premier contact de codage (16C) dans ledit premier jeu (16A à F) et pour connecter électriquement une seconde borne de régulation de commande (44) à un second contact de codage (16D) dans ledit premier jeu (16A à F) ;
un moyen (52) pour connecter électriquement au moins une autre paire sélectionnée de contacts de codage (16A, 16F) dans ledit premier jeu pour former un premier motif de câblage ; et
des moyens (53, 54) pour connecter électriquement au moins deux paires sélectionnées de contacts de codage (16G, I, J, L) dans ledit second jeu pour former un second motif de câblage ;
un moyen de commutation pour appliquer du courant auxdits modules quand ils sont interconnectés seulement si lesdits quatre moyens pour connecter électriquement les contacts respectifs et/ou les bornes forment un circuit fermé qui s'étend en allant et venant entre les modules par l'intermédiaire du panneau entre ladite paire de bornes de régulation de commande (42, 44) ;
et ayant lesdits premier et second motifs de câblage choisis de telle manière qu'il y ait un circuit fermé entre la paire de bornes de régulation de commande (42, 44), lorsque lesdits premier et second modules sont interconnectés, seulement si lesdits premier et second modules sont électriquement compatibles.

2. Système selon la revendication 1, dans lequel lesdites rangées de connecteur sont sensiblement rectangulaires et dans lequel au moins un desdits contacts de codage de module dudit premier jeu est disposé près du sommet (60) de la rangée de connecteurs de module, dans lequel au moins un desdits contacts de codage de module du premier jeu est disposé près du centre (62) de la rangée de connecteurs de module, et dans lequel au moins un desdits contacts de codage de module dudit premier jeu est disposé près du bas (64) de la rangée de connecteurs de module.

3. Système selon la revendication 2, dans lequel lesdites rangées de connecteurs de panneau (22, 24) comprennent des broches de codage de panneau (26) pour faire contact avec lesdits contacts de codage (16A à L) desdites rangées de connecteurs de module lorsque lesdites rangées de connecteurs de module sont connectées auxdites rangées de connecteurs de panneau, et aux broches de signaux et de courant (66), lesdites broches de signaux et de courant (66) étant plus longues que lesdites broches de codage de panneau (26).

4. Système selon l'une quelconque des revendications précédentes, dans lequel ledit moyen de commutation ne fait pas partie de l'un ou l'autre module.
